# EUROPEAN PATENT SPECIFICATION

(11) **EP 1 494 308 B1**
(45) Date of publication and mention of the grant of the patent: **01.09.2010**
(21) Application number: 03715784.9
(22) Date of filing: 08.04.2003
(51) Int. Cl.: H01M 14/00, H01L 31/04

(54) **PHOTOELECTRIC CONVERSION ELEMENT**
FOTOELEKTRISCHES UMWANDLUNGSELEMENT
ELEMENT DE CONVERSION PHOTOELECTRIQUE

(30) Priority: 08.04.2002 JP 2002105792
(43) Date of publication of application: 05.01.2005
(73) Proprietor: Nippon Oil Corporation, Tokyo 105-8412 (JP)
(72) Inventor: UCHIDA, Souichi, Yokohama-shi, Kanagawa 231-0815 (JP); KOBAYASHI, Masaaki, Yokohama-shi, Kanagawa 231-0815 (JP); NISHIKITANI, Yoshinori, Yokohama-shi, Kanagawa 231-0815 (JP)
(74) Representative: Grünecker, Kinkeldey, Stockmair & Schwanhäusser Anwaltssozietät
(86) International application number: PCT/JP2003/004434
(87) International publication number: WO 2003/085773

(56) References cited:
- EP-A- 1 363 293
- EP-A- 1 482 565
- JP-A- 11 086 631
- JP-A- 11 329 519
- JP-A- 2000 306 605
- JP-A- 2001 143 771
- JP-A- 2001 167 807
- JP-A- 2002 063 813
- JP-A- 2002 251 917
- DATABASE WPI Week 199923 Thomson Scientific, London, GB; AN 1999-272779 XP002503084 & JP 11 086631 A (TDK CORP) 30 March 1999 (1999-03-30)
- DATABASE WPI Week 200109 Thomson Scientific, London, GB; AN 2001-074835 XP002503085 & JP 2000 306605 A (DAINIPPON INK & CHEM INC) 2 November 2000 (2000-11-02)
- DATABASE WPI Week 200007 Thomson Scientific, London, GB; AN 2000-080900 XP002503086 & JP 11 329519 A (MINNESOTA MINING & MFG CO) 30 November 1999 (1999-11-30)
- DATABASE WPI Week 200257 Thomson Scientific, London, GB; AN 2002-531294 XP002503087 & JP 2002 063813 A (DAISO CO LTD) 28 February 2002 (2002-02-28)
- DATABASE WPI Week 200146 Thomson Scientific, London, GB; AN 2001-428169 XP002503088 & JP 2001 143771 A (FUJI PHOTO FILM CO LTD) 25 May 2001 (2001-05-25)
- DATABASE WPI Week 200172 Thomson Scientific, London, GB; AN 2001-619953 XP002503089 & JP 2001 167807 A (FUJI PHOTO FILM CO LTD) 22 June 2001 (2001-06-22)
- WATARU KUBO ET AL.: 'Yoyu'en gel denkaishitsu o mochiita shikiso zokan taiyo denchi' THE ELECTROCHEMICAL SOCIETY OF JAPAN DAI 69 KAI TAIKAI KOEN YOSHISHU 01 April 2002, TOKYO, page 256, XP002968896

## Description

### [Filed of the Invention]

The present invention relates to novel photoelectric converting devices.

### [Background of the Invention]

A photoelectric converting device, so-called wet solar cell such as a dye sensitizing solar cell has generally two or more electrodes and an electrolyte therebetween. In such a photoelectric converting device, the electrolyte plays an indispensable role for the functions of the device as a charge transport medium. However, conventional liquid electrolytes have had problems that they leak due to the breakage of the device and evaporate after a long time use.

Typical examples of methods for producing a photoelectric converting device containing a liquid electrolyte include those wherein a liquid electrolyte is poured into spaces between substrates constituting the device and those wherein such substrates are dipped into a liquid electrolyte. In general, these methods invite the complexity of the production processes due to a step for putting a liquid into the slight spaces. Furthermore, these methods are not sufficient in improvements of parts and structure for sealing the liquid in the device for a long period of time and cause deterioration of the appearance of the device and liquid leakage due to the poor durability of the inlet port.

The present invention was made in view of these circumstances and intends to provide a photoelectric converting device with a good appearance and high durability by a simple method using a specific ion conductive film as an electrolyte layer.

### [Disclosures of the Invention]

That is, the present invention relates to a photoelectric converting device according to claim 1 having an electrolyte layer as a charge transport layer, wherein the electrolyte layer is an ion conductive film exhibiting reversible electrochemical oxidation-reduction characteristics.

According to another aspect of the present invention, there is provided the photoelectric converting device wherein the ion conductive film is an ion conductive film comprising a polymeric matrix containing therein a substance exhibiting reversible electrochemical oxidation-reduction characteristics.

According to further another aspect of the present invention, there is provided the photoelectric converting device wherein the ion conductive film contains at least (b) a plasticizer and (c) a substance exhibiting reversible electrochemical oxidation-reduction characteristics in (a) a polymeric matrix.

According to still another aspect of the present invention, there is provided the photoelectric converting device wherein the polymeric matrix is a polyvinylidene fluoride-based polymeric compound.

The present invention will be described in more details below.

The photoelectric converting device of the present invention necessarily contains a charge transport layer. The charge transport layer is usually used by being inserted between a pair of electrode substrates and possesses a function to transport electrons by a substance exhibiting reversible electrochemical oxidation-reduction characteristics contained in the charge transport layer. For example, the oxidized form of the substance exhibiting electrochemical oxidation-reduction characteristics is reduced at one of the electrodes, becomes a reduced form by receiving electrons and diffuses to the other electrode, and turns into the oxidized form again by giving the electrons thereto. The oxidized form diffuses back to the original electrode and receives electrons. This process is substantially equivalent to the flow of electrons through the charge transport layer, and thus the layer functions as an electron transport medium.

The present invention is characterized by the use of an ion conductive film containing a substance exhibiting reversible electrochemical oxidation-reduction characteristics, as a charge transport layer. The term "exhibiting reversible electrochemical oxidation-reduction characteristics" used herein denotes that a reversible electrochemical oxidation-reduction reaction can be induced in the potential range wherein the device works. Typically, the reaction is desirously reversible in a potential range of -1 to +2 V vs NHE (normal hydrogen electrode).

No particular limitation is imposed on the ion conductive film as long as it contains the above-mentioned substance exhibiting reversible electrochemical oxidation-reduction characteristics. Preferred examples of the ion conductive film include those containing at least (c) a substance exhibiting electrochemical reversible oxidation-reduction characteristics (Component (c)) and if necessary further containing (b) a plasticizer (Component (b)), in (a) a polymeric matrix (Component (a)). In addition to these components, optional components described later may be added if necessary. The ion conductive film is formed in a solid or gelled state by Component (b) or Components (b) and (c) or additional optional components retained in Component (a).

No particular limitation is imposed on materials usable for Component (a), i.e., polymeric matrix as long as they can be formed in a solid or gelled state by themselves or by addition of a plasticizer or a supporting electrolyte or the combination thereof. Polymeric compounds which have been generally used can be used in the present invention.

Examples of polymeric compounds exhibiting characteristics which the polymeric matrix exhibits include polymeric compounds such as polyhexafluoropropylene, polytetrafluoroethylene, polytrifluoroethylene, polyethylene, polypropylene, polyacrylonitrile, polyvinylidene chloride, polyacrylic acid, polymethacrylic acid, polymethylacrylate, polyethylacrylate, polymethylmethacrylate, polystyrene, and polyvinylidene fluoride. These polymeric compounds may be used individually or mixed. Alternatively, copolymers obtained by copolymerizing various monomers may be used. In the present invention, polyvinylidene fluoride-based polymeric compounds are particularly preferably used.

Examples of the polyvinylidene fluoride-based polymeric compounds include homopolymers of polyvinylidene fluoride and copolymers of polyvinylidene fluoride and another polymerizable monomer, preferably a radical polymerizable monomer. Examples of the another polymerizable monomer (hereinafter referred to as "copolymerizable monomer") to be copolymerized with polyvinylidene fluoride include hexafluoropropylene, tetrafluoroethylene, trifluoroethylene, ethylene, propylene, acrylonitrile, vinylidene chloride, acrylic acid, methacrylic acid, methylacrylate, ethylacrylate, methylmethacrylate, and styrene.

These copolymerizable monomers may be used in an amount of 1 to 50 percent by mol, preferably 1 to 25 percent by mol, based on the total mass of the monomer.

Hexafluoropropylene is preferably used as the copolymerizable monomer. An ion conductive film containing a vinylidene fluoride-hexafluoropropylene copolymer obtained by copolymerizing 1 to 25 percent by mol of hexafluoropropylene with vinylidene fluoride, as the polymeric matrix is preferably used in the present invention. A mixture of two or more types of vinylidene fluoride-hexafluoropropylene copolymers with different copolymerization ratios may also be used.

Alternatively, two or more of these copolymerizable monomers may be copolymerized with vinylidene fluoride. For example, copolymers may be used which copolymers are obtained by copolymerizing vinylidene fluoride, hexafluoropropylene and tetrafluoroethylene; vinylidene fluoride, hexafluoropropylene and acrylic acid; vinylidene fluoride, tetrafluoroethylene and ethylene; or vinylidene fluoride, tetrafluoroethylene and propylene.

Furthermore, in the present invention, the polymeric matrix may be a mixture of a polyvinyliden fluoride-based polymeric compound and one or more polymeric compounds selected from the group consisting of polyacrylic acid-based polymeric compounds, polyacrylate-based polymeric compounds, polymethacrylic acid-based polymeric compounds, polymethacrylate-based polymeric compounds, polyacrylonitrile-based polymeric compounds, and polyether-based polymeric compounds. Alternatively, a polyvinylidene fluoride-based polymeric compound may be mixed with one or more copolymer obtained by copolymerizing two or more monomers of the above-mentioned polymeric compounds. The blend ratio of the homopolymers or copolymers is usually 200 parts by mass or less, based on 100 parts by mass of the polyvinylidene fluoride-based polymeric compound.

In the present invention, preferred polyvinylidene fluoride-based polymeric compounds are those having a weight-average molecular weight of generally from 10,000 to 2,000,000, preferably from 100,000 to 1,000,000.

The plasticizer used in the present invention will be described next.

The plasticizer used in the present invention acts as a solvent of Component(c), i.e., a substance exhibiting reversible electrochemical oxidation-reduction characteristics. Any type of plasticizers may be used as long as it can be generally used as an electrolyte solvent for electrochemical cells or electric cells. Specific examples include acetic anhydride, methanol, ethanol, tetrahydrofuran, propylene carbonate, nitromethane, acetonitrile, dimethylformamide, dimethylsulfoxide, hexamethylphosphoamide, ethylene carbonate, dimethoxyethane, γ-butyrolactone, γ-valerolactone, sulfolane, propionitrile, glutaronitrile, adiponitrile, methoxyacetonitrile, dimethylacetoamide, methylpyrrolidinone, dimethylsulfoxide, dioxolan, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol. Particularly preferred examples include propylene carbonate, ethylene carbonate, dimethylsulfoxide, dimethoxyethane, acetonitrile, γ -butyrolactone, sulfolane, dioxolan, dimethylformamide, tetrahydrofuran, adiponitrile, methoxyacetonitrile, dimethylacetoamide, methylpyrrolidinone, dimethylsulfoxide, trimethyl phosphate, and triethyl phosphate. Alternatively, ordinary-temperature melting salts may be used. The term "ordinary-temperature melting salt" used herein denotes a salt comprising only ion pairs but no solvent component, in a melted state (liquid state) at ordinary temperature, more specifically a salt comprising ion pairs which has a melting point of 20 °C or below and will be in a liquid state at a temperature exceeding 20 °C.

Examples of the ordinary-temperature melting salt include those represented by the following formulas: 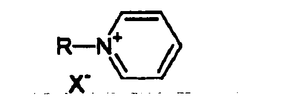 wherein R is an alkyl group having 2 to 20, preferably 2 to 10 carbon atoms and X⁻ is a halogen ion or SCN⁻; 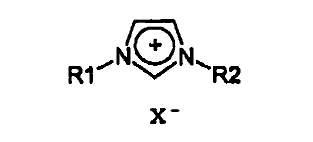 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a halogen ion or SCN⁻; 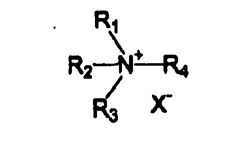 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a halogen ion or SCN⁻.

These plasticizers may be used individually or in combination.

No particular limitation is imposed on the amount of the plasticizer to be used. The plasticizer may be contained in an amount of 20 percent by mass or more, preferably 50 percent by mass or more, and further preferably 70 percent by mass or more and 98 percent by mass or less, preferably 95 percent by mass or less, and further preferably 90 percent by mass or less, in the ion conductive film.

Next described will be Component (c), i.e., substance exhibiting reversible electrochemical oxidation-reduction characteristics.

Component (c) is a compound capable of inducing the above-described reversible electrochemical oxidation-reduction reaction and is generally referred to as a redox agent.

No particular limitation is imposed on the type of such a compound. Examples of the compound include ferrocene, p-benzoquinone, 7,7,8,8-tetracyanoquinodimethane, N,N,N',N'-tetramethyl-p-phenylenediamine, tetrathiafulvalene, anthracene, and p-toluylamine. The compound may also be LiI, NaI, KI, CsI, CaI₂, iodine salts of quaternary imidazolium, iodine salts of tetraalkylammonium, and Br₂ and metal bromides such as LiBr, NaBr, KBr, CsBr or CaBr₂.

Further, the compound may be Br₂ and tetraalkylammoniumbromide, bipyridiniumbromide, bromine salts, complex salts such as ferrocyanic acid-ferricyanate, sodium polysulfide, alkylthiol-alkyldisulfide, hydroquinone-quinone, or viologen. The redox agent may be only either one of an oxidized form or a reduced form or a mixture thereof mixed at a suitable molar ratio.

Particular examples of Component (c) include salts having a counter anion (X⁻) selected from halogen ions and SCN⁻. Examples of such salts include quaternary ammonium salts such as (CH₃)₄N⁺X⁻, (C₂H₅)₄N⁺X⁻, (n-C₄H₉)₄N⁺X⁻, and those represented by the following formulas: 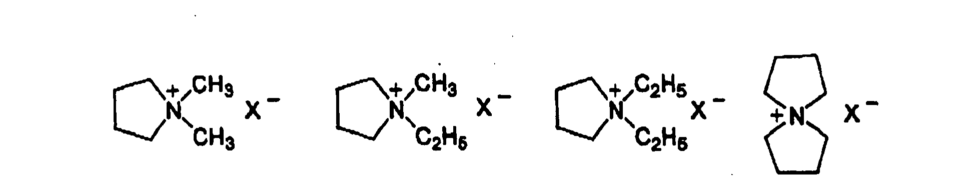 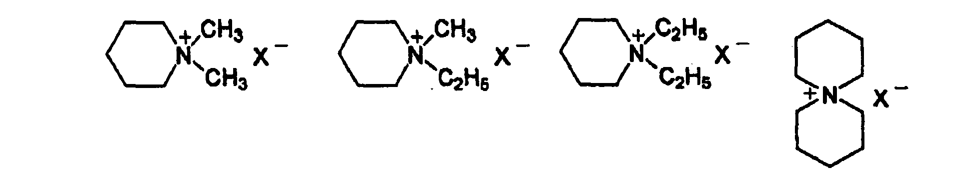 and phosphonium salts such as (CH₃)₄P⁺X⁻, (C₂H₅)₄P⁺X⁻, (C₃H₇)₄P⁺X⁻, and (C₄H₉)₄P⁺X⁻.

Needless to mention, mixtures of these compounds may be properly used.

These compounds are preferably used in combination with Component (b).

Alternatively, redox ordinary-temperature melting salts may be used as Component (c). The term "redox ordinary-temperature melting salts" denotes salts comprising only ion pairs but no solvent component, in a melted state (liquid state) at ordinary temperature, more specifically salts comprising ion pairs which salts have a melting point of 20 °C or below and will be in a liquid state at a temperature exceeding 20 °C and are capable of inducing a reversible electrochemical oxidation-reduction reaction. When the redox ordinary-temperature melting salts are used as Component (c), Component (b) may or may not be used in combination.

One of the redox ordinary-temperature melting salts may be used or alternatively two or more thereof may be mixed.

Examples of the redox ordinary-temperature melting salt include those represented by the following formulas: 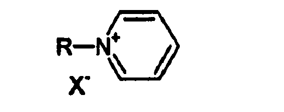 wherein R is an alkyl group having 2 to 20, preferably 2 to 10 carbon atoms and X⁻ is a halogen ion or SCN⁻; 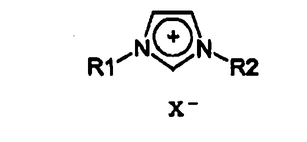 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a halogen ion or SCN⁻; 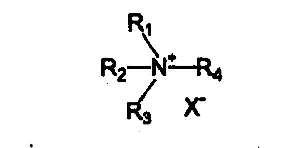 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a halogen ion or SCN⁻.

No particular limitation is imposed on the amount of Component (c). Component (c) may be generally contained in an amount of usually 0.1 percent by mass or more, preferably 1 percent by mass or more, more preferably 10 percent by mass or more and 70 percent by mass or less, preferably 60 percent by mass or less, more preferably 50 percent by mass or less, in the ion conductive film.

When Component (c) is used in combination with Component (b), the mix ratio is desirously selected such that Component (c) is dissolved in Component (b) and does not precipitate after being formed into the ion conductive film. The mix ratio by mass of Component (c)/Component (b) is in the range of preferably 0.01 to 0.5, more preferably 0.03 to 0.3.

The mass ratio of Component (a)/(Components (b) and (c)) is within the range of preferably 1/20 to 1/1, more preferably 1/10 to 1/2.

The ion conductive film of the present invention may contain optional components other than the above-described components to an extent that the effects achieved by the invention are not impaired.

Examples of typical optional components include supporting electrolytes, ultraviolet absorbing agents, and amine compounds.

The supporting electrolyte may be salts, acids, alkalis, ordinary-temperature melting salts which are generally used in the field of electrochemistry or electric batteries.

No particular limitation is imposed on the salts. For example, the salts may be inorganic ion salts such as alkali metal salts and alkaline earth metal salts, quaternary ammonium salts, cyclic quaternary ammonium salts, and quaternary phosphonium salts. Particularly preferred are Li salts.

Specific examples of the salts include Li, Na, and K salts having a counter anion selected from ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

The salts may also be any of quaternary ammonium salts having a counter anion selected from ClO₄⁻, BF₄⁻, CF₃SO₃⁻, (CF₃SO₂)₂N⁻, (C₂F₅SO₂)₂N⁻, PF₆⁻, ASF₆⁻, CH₃COO⁻, CH₃(C₆H₄)SO₃⁻, and (C₂F₅SO₂)₃C⁻, more specifically (CH₃)₄N⁺BF₄⁻, (C₂H₅)₄N⁺BF₄⁻, (n-C₄H₉)₄N⁺BF₄⁻, (C₂H₅ )₄N⁺ClO₄⁻, (n-C₄H₉)₄N⁺ClO₄⁻, CH₃(C₂H₅)₃N⁺BF₄⁻, (CH₃)₂(C₂H₅)₂N⁺BF₄⁻, (CH₃)₄N⁺SO₃CF₃⁻, (C₂H₅)₄N⁺SO₃CF₃⁻, (n-C₄H₉)₄N⁺SO₃CF₃⁻, and those represented by the following formulas:

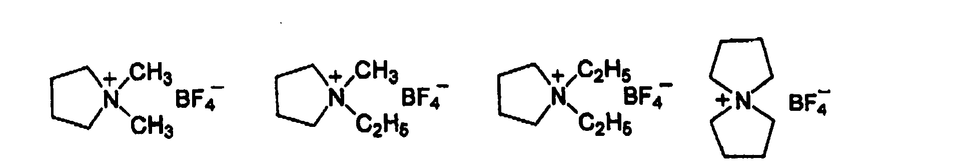

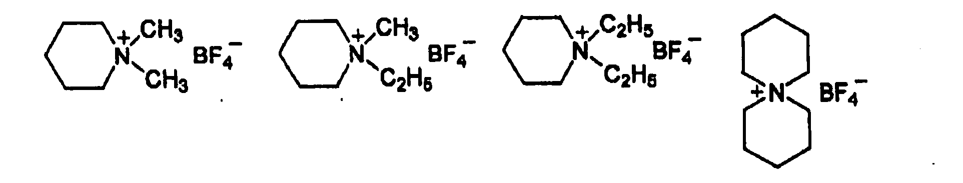

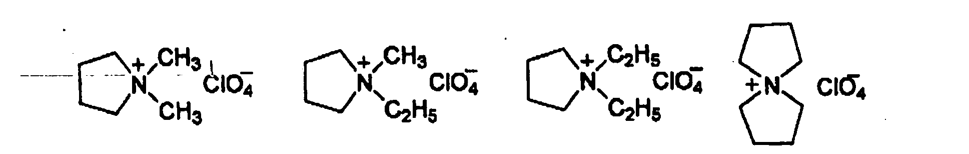

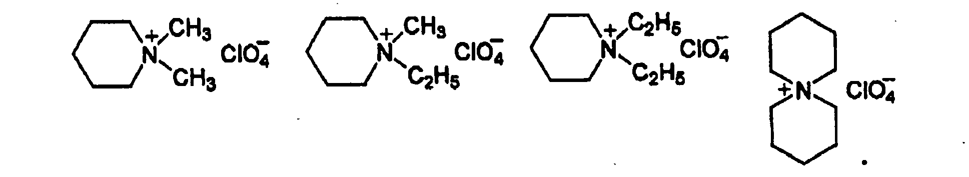

Furthermore, the salts may be any of phosphonium salts having a counter anion selected from ClO₄⁻, BF₄⁻, CF₃SO₃⁻, (CF₃SO₂)₂N⁻, (C₂F₅SO₂)₂N⁻, PF₆⁻_{'} AsF₆⁻, CH₃COO⁻, CH₃(C₆H₄)SO₃⁻, and (C₂F₅SO₂)₃C⁻. More specific examples include (CH₃)₄P⁺BF₄⁻, (C₂H₅)₄P⁺BF₄⁻, (C₃H₇)₄P⁺BF₄⁻, and (C₄H₉)₄P⁺BF₄⁻.

Mixtures of these compounds may be suitably used in the present invention.

No particular limitation is imposed on the acids, which, therefore, may be inorganic acids or organic acids. Specific examples of the acids are sulfuric acid, hydrochloric acid, phosphoric acids, sulfonic acids, and carboxylic acids.

No particular limitation is imposed on the alkalis which, therefore, may be sodium hydroxide, potassium hydroxide, and lithium hydroxide.

No particular limitation is imposed on the ordinary-temperature melting salts. The ordinary-temperature melting salts used in the present invention are those comprising only ion pairs but no solvent component, in a melted state (liquid state) at ordinary temperature, more specifically salts comprising ion pairs which salts have a melting point of 20 °C or below and will be in a liquid state at a temperature exceeding 20 °C.

One of the ordinary-temperature melting salts may be used or alternatively two or more thereof may be mixed.

Examples of the ordinary-temperature melting salt include those represented by the following formulas: 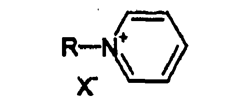 wherein R is an alkyl group having 2 to 20, preferably 2 to 10 carbon atoms and X⁻ is a counter anion selected

from ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; 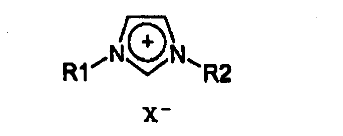 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a counter anion selected from ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; and 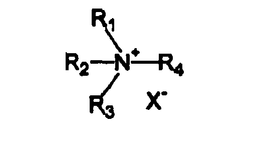 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a counter anion selected from ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

No particular limitation is imposed on the amount of the supporting electrolyte to be used. The supporting electrolyte may be contained in an amount of usually 0.1 percent by mass more, preferably 1 percent by mass or more, and more preferably 10 percent by mass or more and 70 percent by mass or less, preferably 60 percent by mass or less, and more preferably 50 percent by mass or less, in the ion conductive film.

No particular limitation is imposed on the ultraviolet absorbing agent which the ion conductive film contains. Typical examples of the ultraviolet absorbing agent include organic ultraviolet absorbing agents such as compounds having a benzotriazole molecule structure or a benzophenone molecule structure.

Examples of the compound having a benzotriazole molecule structure include those represented by formula (1) below:

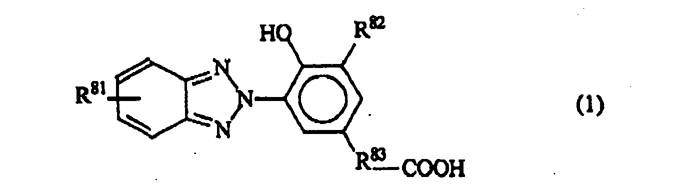

In formula (1), R⁸¹ is hydrogen, halogen or an alkyl group having 1 to 10, preferably 1 to 6 carbon atoms. Specific examples of the halogen are fluorine, chlorine, bromine, and iodine. Specific examples of the alkyl group include methyl, ethyl, propyl, i-propyl, butyl, t-butyl and cyclohexyl groups. R⁸¹ is usually substituted at the 4- or 5-position of the benzotriazole ring but the halogen and the alkyl group are usually located at the 4-position. R⁸² is hydrogen or an alkyl group having 1 to 10, preferably 1 to 6 carbon atoms. Examples of the alkyl group include methyl, ethyl, propyl, i-propyl, butyl, t-butyl, and cyclohexyl groups. R⁸³ is an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

Specific examples of the compounds represented by formula (1) include
3-(5-chloro-2H-benzotriazole-2-yl)-5-(1,1-dimethylethyl)-4-hydroxy-benzene propanoic acid,
3-(2H-benzotriazole-2-yl)-5-(1,1-dimethylethyl)-4-hydroxy-benzene ethanoic acid,
3-(2H-benzotriazole-2-yl)-4-hydroxybenzene ethanoic acid,
3-(5-methyl-2H-benzotriazole-2-yl)-5-(1-methylethyl )-4-hydroxybenzene propanoic acid,
2-(2'-hydroxy-5'-methylphenyl)benzotriazole,
2-[2'-hydroxy-3',5'-bis(α,α-dimethylbenzyl) phenyl] benzotriazole, 2-(2'-hydroxy-3',
5'-di-t-butylphenyl)benzotriazol,
2-(2'-hydroxy-3'-t-butyl-5'-methylphenyl)-5-chloro benzotriazole, and
3-(5-chloro-2H-benzotriazole-2-yl)-5-(1,1-dimethyl ethyl)-4-hydroxy-benzene propanoic acid octylester.

Specific examples of the compound having a benzophenone molecule structure include those represented by the following formulas:

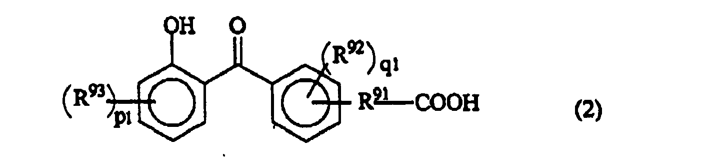

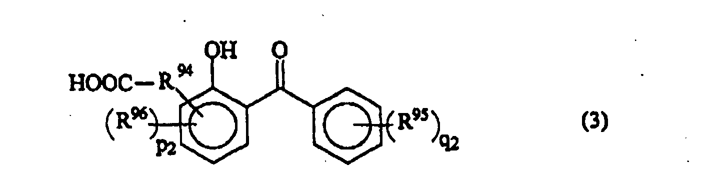

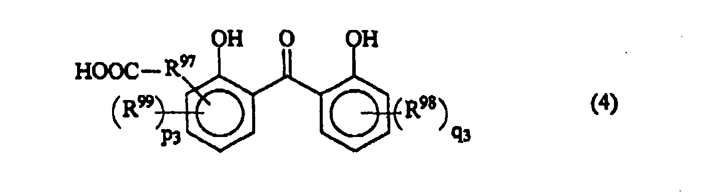

In formulas (2) to (4), R⁹², R⁹³, R⁹⁵, R⁹⁶, R⁹⁸, and R⁹⁹ may be the same or different from each other and are each independently a hydroxyl group or an alkyl or alkoxy group having 1 to 10, preferably 1 to 6 carbon atoms. Examples of the alkyl group include methyl, ethyl, propyl, i-propyl, butyl, t-butyl, and cyclohexyl groups. Specific examples of the alkoxy group are methoxy, ethoxy, propoxy, i-propoxy, and butoxy groups.

R⁹¹, R⁹⁴, and R⁹⁷ are each independently an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

In the above formulas, p1, p2, p3, q1, q2, and q3 are each independently an integer of 0 to 3.

Preferred examples of the compounds having a benzophenone molecule structure, represented by formulas (2) to (4) include 2-hydroxy-4-methoxybenzophenone-5-carboxylic acid, 2,2'-dihydroxy-4-methoxybenzophenone-5-carboxylic acid, 4-(2-hydroxybenzoyl)-3-hydroxybenzen propanoic acid, 2,4-dihydroxybenzophenone, 2-hydroxy-4-methoxybenzophenone, 2-hydroxy-4-methoxybenzophenone-5-sulfonic acid, 2-hydroxy-4-n-octoxybenzophenone, 2,2'-dihydroxy-4,4'-dimethoxybenzophenone, 2,2',4,4'-tetrahydroxybenzophenone, and 2-hydroxy-4-methoxy-2'-carboxybenzophenone.

Needless to mention, two or more of these ultraviolet absorbing agents may be used in combination.

The use of the ultraviolet absorbing agent is optional. No particular limitation is imposed on the amount of the ultraviolet absorbing agent to be used. However, if the agent is used, it may be contained in an amount of 0.1 percent by mass or more, preferably 1 percent by mass or more and 20 percent by mass or less and preferably 10 percent by mass or less, in the ion conductive film.

No particular limitation is imposed on the amine compounds which the ion conductive film may contain. Various aliphatic and aromatic amines can be used. Typical examples of the amine compound include pyridine derivatives, bipyridine derivatives, and quinoline derivatives. It is expected that the open-circuit voltage is enhanced by addition of these amine compounds. Specific examples of these compounds include 4-t-butyl-pyridine, quinoline, and isoquinoline.

The method for producing the ion conductive film of the present invention will be described next.

The ion conductive film of the present invention can be easily produced by any of conventional film forming methods. For example, the ion conductive film containing the above-described Components (a), (b), and (c) and the above-described optional components to be added if necessary is obtained by forming a mixture of these components into a film by a conventional method. No particular limitation is imposed on the film forming method. Examples of the method include extrusion, casting, soin-coating, and dip-coating methods.

Extrusion may be conducted in a conventional manner wherein the above-described components are mixed and formed into a film after being heat-melted.

Casting is conducted by mixing the above-described components, adjusting the viscosity of the mixture by adding a suitable diluent, and coating and drying the diluted mixture with a conventional coater normally used for casting thereby forming the mixture into a film. Examples of the coater include doctor coaters, blade coaters, rod coaters, knife coaters, reverse roll coaters, gravure coaters, spray coaters, and curtain coaters among which a suitable one is selected depending on the viscosity and film thickness.

Spin coating is conducted by mixing the above-described components, adjusting the viscosity of the mixture by adding a suitable diluent, and coating and drying the diluted mixture with a commercially available spin-coater thereby forming the mixture into a film.

Dip coating is conducted by mixing the above-described components, adjusting the viscosity of the mixture by adding a suitable diluent so as to obtain a solution of the mixture, dipping and lifting a suitable substrate therein, and drying the substrate thereby forming the mixture into a film.

The ion conductive film of the present invention exhibits an ion conductivity of generally 1 x 10⁻⁷ S/cm or higher, preferably 1 x 10⁻⁶ S/cm or higher, and more preferably 1 x 10⁻⁵ S/cm or higher, at room temperatures. The ion conductivity can be sought by a conventional method such as complex impedance method.

The oxidized form of the ion conductive film of the present invention has a diffusion coefficient of 1 x 10⁻⁹ cm²/s or higher, preferably 1 x 10⁻⁸ cm²/s or higher, and more preferably 1 x 10⁻⁷ cm²/s or higher. The diffusion coefficient is one of the indices indicating ion conductivity and can be sought by any of conventional techniques such as a constant potential current characteristics measurement and a cyclic voltammogram measurement.

No particular limitation is imposed on the thickness of the ion conductive film. The thickness is usually 1 µm or more, preferably 10 µm or more and 3 mm or less, preferably 1 mm or less.

The ion conductive film of the present invention preferably has self-standing properties. In this case, the ion conductive film has a tensile modulus of elasticity at 25 °C of usually 5 x 10⁴ N/m² or more, preferably 1 x 10⁵ N/m² or more, and most preferably 5 x 10⁵ N/m². The tensile modulus of elasticity is a value obtained by measuring the tensile modulus of elasticity of a strip sample with a size of 2 cm x 5 cm using a conventional tensile tester.

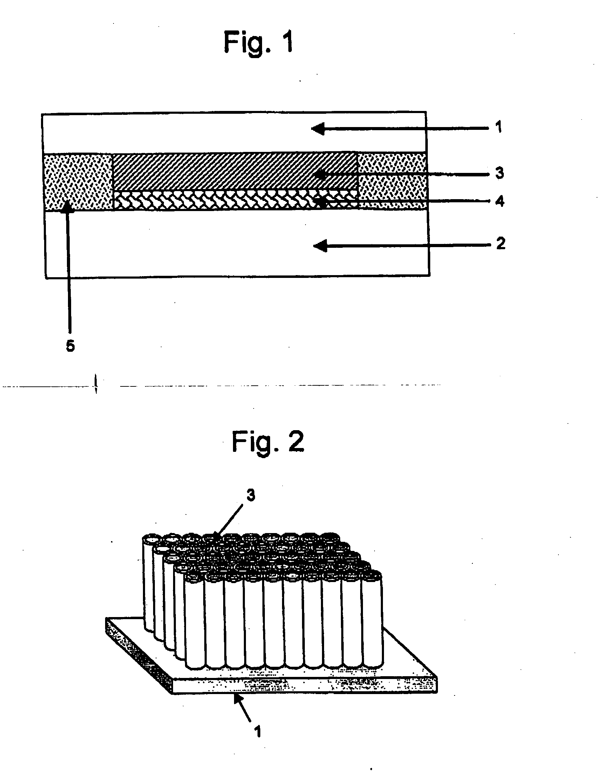

A photoelectric converting device according to the present invention has a layered structure represented by a structure shown in Fig. 1 and contains at least two sheets of electrically conductive substrates at least one of which is substantially transparent and a so-called transparent electrically conductive substrate. A semiconductor layer (photosensitive layer) is usually formed on the transparent electrically conductive substrate as shown in Fig. 1.

The transparent electrically conductive layer usually has a transparent electrode layer on a transparent substrate.

No particular limitation is imposed on the transparent substrate. The material, thickness, size, and shape of the substrate can be properly selected depending on the purposes. For example, the substrate may be selected from colored or colorless glasses, wire-reinforced glasses, glass blocks, and colored or colorless transparent resins. Specific examples are polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes. The term "transparent" used herein denotes a transmissivity of 10 to 100 percent, preferably 50 percent or higher. The substrates used herein are those having a smooth surface at ordinary temperatures, which surface may be flat or curved or deformed with stress.

No particular limitation is imposed on the transparent electrode layer acting as an electrode as long as it can achieve the purposes of the present invention. For example, the layer may be a metal film of gold, silver, chromium, copper, or tungsten or an electrically conductive film made of a metal oxide. Preferred examples of the metal oxide include those obtained by doping to tin oxide or zinc oxide trace amounts of components such as Indium Tin Oxide (ITO (In₂O₃:Sn)), Fluorine doped Tin Oxide (FTO (SnO₂:F)), and Aluminum doped Zinc Oxide (AZO (ZnO:Al)).

The film thickness is usually from 50 nm to 5,000 nm, preferably from 100 nm to 3,000 nm. The surface resistance (resistivity) is properly selected depending on the use of the substrate in the present invention, but is usually from 0.5 to 500 Ω/sq, preferably from 2 to 50 Ω/sq.

No particular limitation is imposed on the method of forming the transparent electrode layer. The method is properly selected from any conventional methods depending on the type of the above-described metal or metal oxide used as the electrode layer. In general, the method is selected from vacuum deposition, ion plating, CVD, and sputtering. In any of the methods, the transparent electrode layer is desirously formed at a substrate temperature of 20 to 700 °C.

The other substrate, i.e., counter substrate may have electric conductivity by itself or on at least one surface and thus may be a transparent electrically conductive substrate as described above or an opaque electrically conductive substrate. Examples of the opaque electrically conductive substrate include various metal electrodes as well as Au, Pt, and Cr formed into a film on a glass substrate.

No particular limitation is imposed on the semiconductor layer to be used in the photoelectric converting device of the present invention. Examples of the semiconductor include Bi₂S₃, CdS, CdSe, CdTe, CuInS₂, CuInSe₂, Fe₂O₃, GaP, GaAs, InP, Nb₂O₅, PbS, Si, SnO₂, TiO₂, WO₃, ZnO, and ZnS, among which preferred are CdS, CdSe, CuInS₂, CuInSe₂, Fe₂O₃, GaAs, InP, Nb₂O₅, PbS, SnO₂, TiO₂, WO₃, and ZnO. These materials may be used in combination. Particularly preferred are TiO₂, ZnO, SnO₂, and Nb₂O₅, while most preferred are TiO₂ and ZnO.

The semiconductor used in the present invention may be monocrystalline or polycrystalline. For example, the crystal system of TiO₂ may be selected from those of anatase, rutile, or brookite type among which preferred are those of anatase type. The semiconductor layer may be formed by any suitable conventional manner.

The semiconductor layer may be obtained by coating a nanoparticle dispersant or sol solution, of the above-mentioned semiconductor on the substrate by any conventional method. No particular limitation is imposed on the coating method. Therefore, the coating may be conducted by a method wherein the semiconductor is obtained in the form of film by casting; spin-coating; dip-coating; bar-coating; and various printing methods such as screen-printing.

Alternatively, the semiconductor layer may be produced by a liquid phase particle growth method described in "Chem. Lett., 433 (1996)" by Shigehito Deki, Yoshifumi Aoi, Osamu Hiroi and Akihiko Kajinami and "Thin Solid Films, 351, 220 (1999)" by Kazuhiko Shimizu, Hiroaki Imai, Hiroshi Hirashima and Koji Tsukuma; an electrophoresis method described in "Chem. Lett., 1250 (2002)" by Tsutomu Miyasaka, Yujiro Kijitori, Takurou N. Murakami, Mitsuhiro Kimura, and Sadao Uegusa; an electrodeposition method described in "Chem. Lett., 78 (2001)" by S. Karuppuchamy, D.P. Amalnerkar, K. Yamaguchi, T. Yoshida, T. Sugiura, and H. Minoura and "J. Electroanal. Chem., 481, 42 (2000)" by D. Schlettwein, T. Oekermann, T. Yoshida, M. Tochimoto, and H. Minoura; and a pressuring method described in "J. Photochem. Photobio A Chem., 145, 107 (2001)" by H. Lindström, A. Holmberg, E. Magnusson, L. Malmqvist, and A. Hagfeldt.

Further alternatively, a semiconductor layer with high regularity may be produced in micropores of a nanoporus alumina with high regularity used as a mold, applying any of the above-described semiconductor producing methods, as described in "Science, 268, 1466 (1995)" by Hideki Masuda and Kenji Fukuda. Further alternatively, a semiconductor layer with high regularity may also be produced by methods described in "J. Mater. Sci. Lett., 15, 1228 (1996)" by Patrick Hoyer and Hideki Masuda; "Langmuir, 12, 1411 (1996)" by Patrick Hoyer; and "Chem. Mater. 14, 266 (2002)" by S.-Z. Chu, K. Wada, S. Inoue, and S. Todoroki.

The thickness of the semiconductor layer may be arbitrarily selected but is 0.5 µm or more and 50 µ m or less, preferably 1 µm or more and 20 µm or less.

For the purpose of enhancing the light-absorbing efficiency of the semiconductor layer, various dyes may be absorbed to or contained in the layer.

No particular limitation is imposed on the dye to be used in the present invention as long as it can enhance the light-absorbing efficiency of the semiconductor layer. One or more of various metal complex dyes and organic dyes may be usually used. In order to improve the absorptivity to the semiconductor layer, dyes having in their molecules a functional group such as carboxyl, hydroxyl, sulfonyl, phosphonyl, carboxylalkyl, hydroxyalkyl, sulfonylalkyl, and phosphonylalkyl groups are preferably used.

Eligible metal complex dyes are a complex of ruthenium, osmium, iron, cobalt, or zinc; metal phthalocyanine; and chlorophyll.

Examples of the metal complex dyes used in the present invention include those represented by the following formulas:

### (Dye 1)

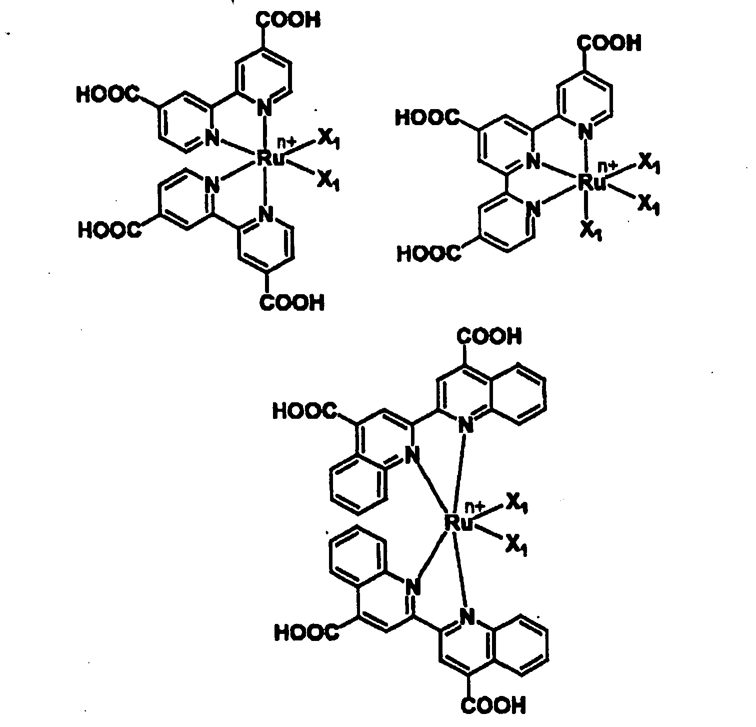

wherein X₁ is a univalent anion and two or three X₁ may be independent of each other or cross-linked and are any of those represented by the following formulas:

**⁻N=C=S ⁻N=C=NAr Cl^{- -}C≡N**

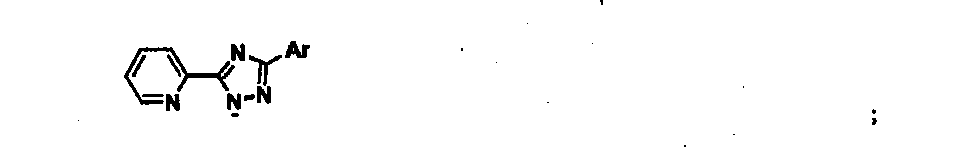

### (Dye 2)

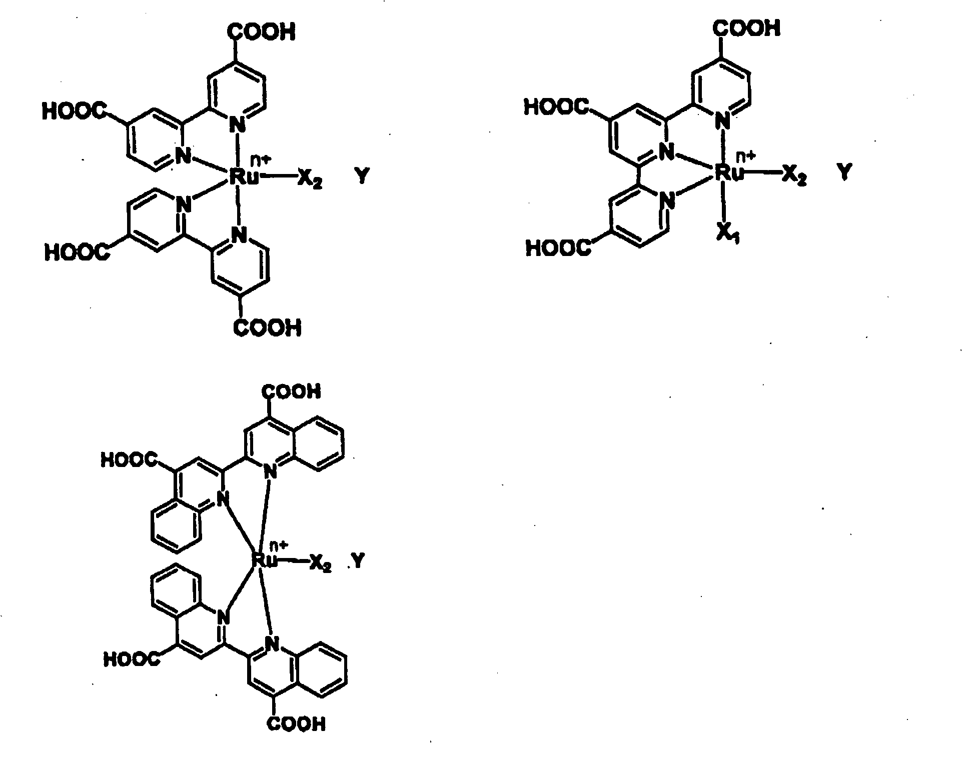

wherein X₁ is the same as that of Dye 1 and X₂ is a univalent anion and may be any of those represented by the following formulas: 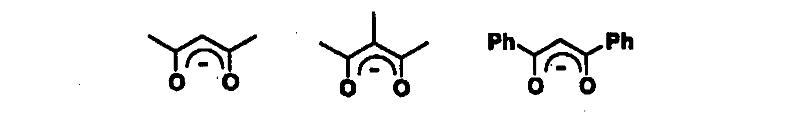 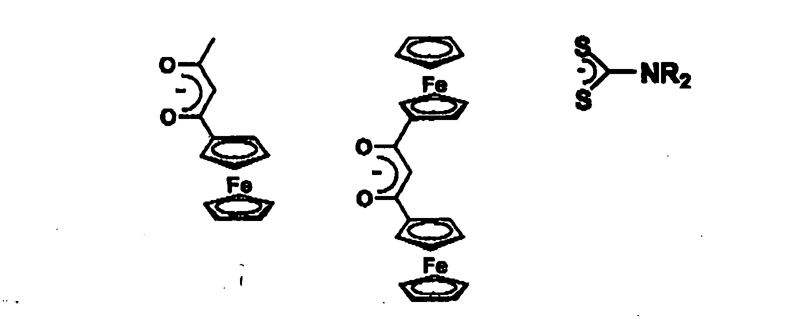 wherein Y is a univalent anion and may be any of halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻;

### (Dye 3)

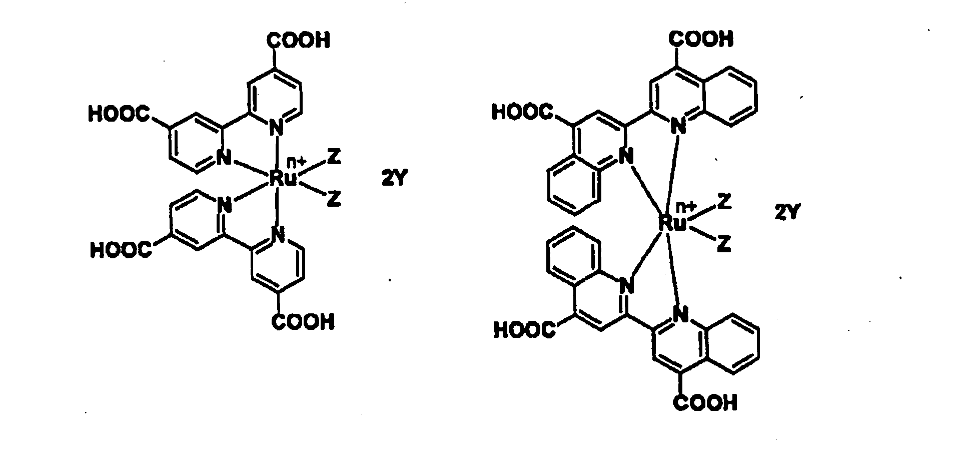

wherein Z is an atomic group having an unshared electron pair, and two Z may be independent of each other or cross-linked and any of those represented by the following formulas: 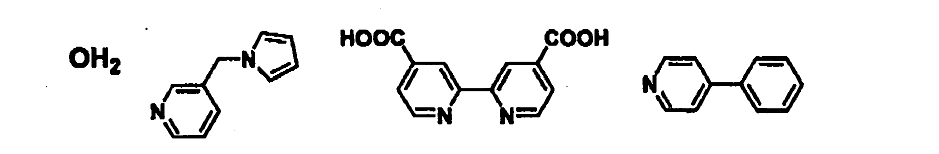 and Y is an univalent anion and may be any of halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; and

### (Dye 4)

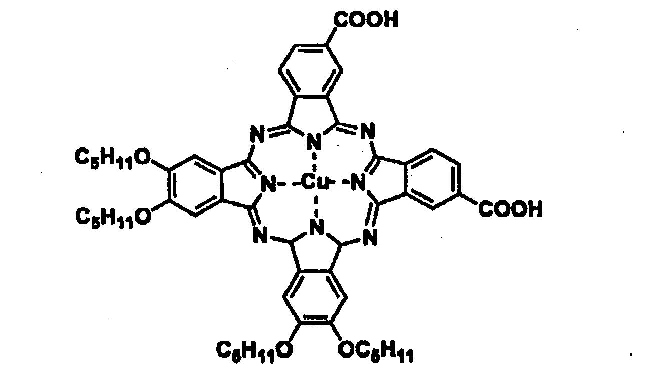

Eligible organic dyes are cyanine-based dyes, hemicyanine-based dyes, merocyanine-based dyes, xanthene-based dyes, triphenylmethane-based dyes, and metal-free phthalocyanine-based dyes. Examples of the dyes used in the present invention include those represented by the following formulas:

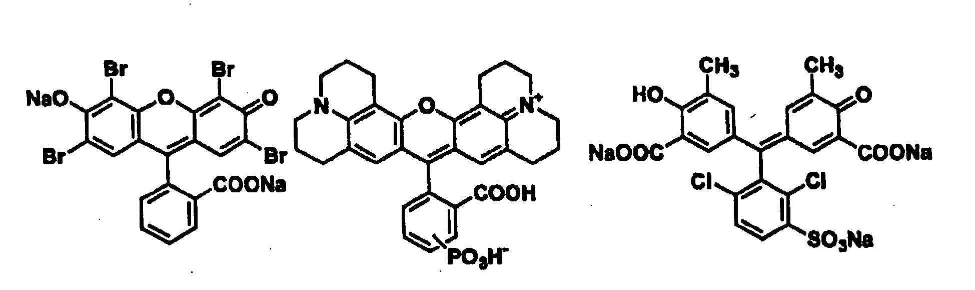

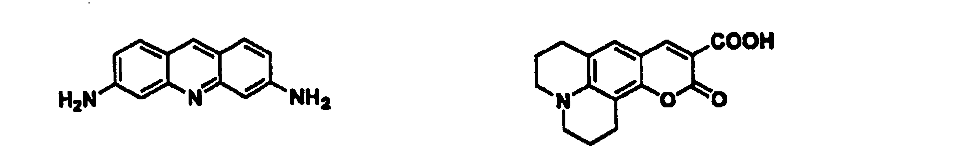

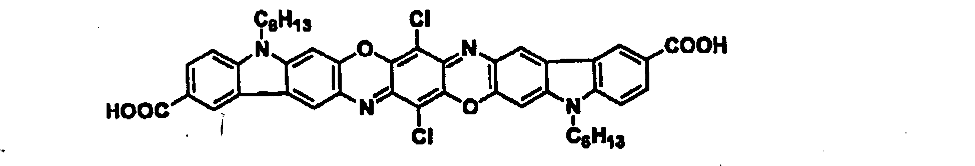

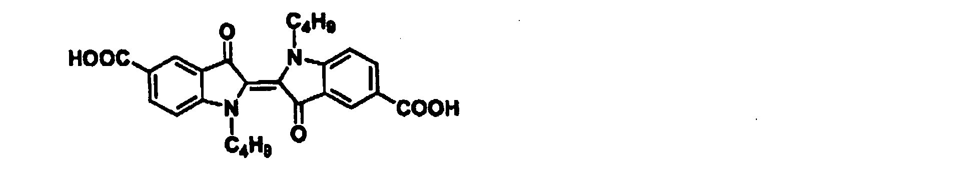

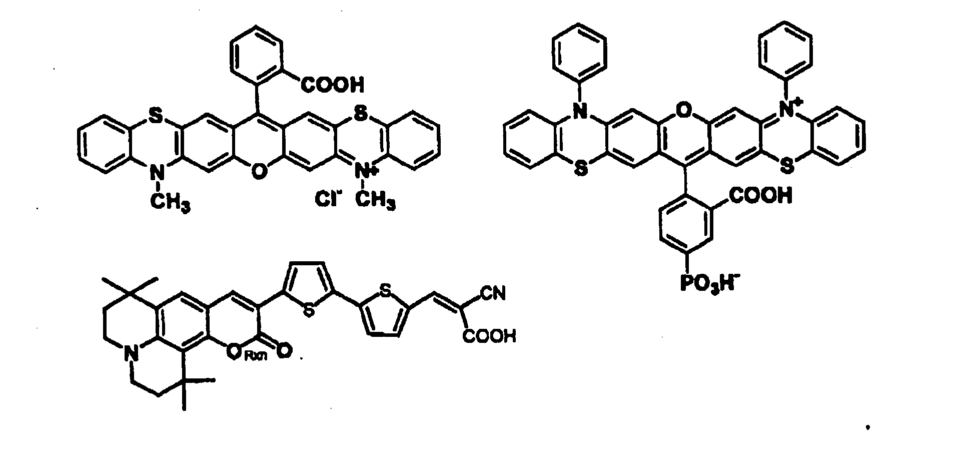

The dye may be absorbed to the semiconductor layer on a transparent electrically conductive substrate by coating a solution obtained by dissolving the dye in a solvent on the semiconductor layer by spray- or spin-coating and drying the solution. In this case, the substrate may be heated to a suitable temperature. Alternatively, the dye may be absorbed to the semiconductor layer by dipping the layer into the solution. No particular limitation is imposed on the time for dipping as long as the dye is sufficiently absorbed to the semiconductor layer. The substrate is dipped into the solution for preferably 1 to 30 hours, particularly preferably 5 to 20 hours. If necessary, the solvent or the substrate may be heated upon dipping. The concentration of the dye in the solution is preferably from 1 to 1,000 mM/L, more preferably from 10 to 500 mM/L.

No particular limitation is imposed on the solvent to be used as long as it dissolves the dye but not the semiconductor layer. Examples of the solvent include alcohols such as methanol, ethanol, 1-propanol, 2-propanol, 1-butanol, 2-butanol, and t-butanol, nitrile-based solvents such as acetonitrile, propionitrile, methoxypropionitrile, and glutaronitrile, benzene, toluene, o-xylene, m-xylene, p-xylene, pentane, heptane, hexane, cyclohexane, heptane, ketones such as acetone, methyl ethyl ketone, diethyl ketone, and 2-butanone, diethylether, tetrahydrofuran, ethylene carbonate, propylene carbonate, nitromethane, dimethylformamide, dimethylsulfoxide, hexamethylphosphoamide, dimethoxyethane, γ -butyrolactone, γ -valerolactone, sulfolane, adiponitrile, methoxyacetonitrile, dimethylacetoamide, methylpyrrolidinone, dioxolan, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol.

The photoelectric converting device of the present invention is exemplified by the one having a cross-section shown in Fig. 1. This device is formed by a transparent electrically conductive substrate 1 (substrate A), a semiconductor layer 3 to which a dye is absorbed, a counter electrode substrate 2 (substrate B), and an ion conductive film 4 disposed between the semiconductor layer 3 and the counter electrode substrate 2. The peripheral space of the device is sealed with a sealant. Lead wires are connected to the electrically conductive portions of substrates A and B and can take out electric power.

No particular limitation is imposed on the method of producing a solar battery using the photoelectric converting device of the present invention. In general, the solar battery can be easily produced by laminating substrate A having the semiconductor layer absorbing the dye, the ion conductive film, and substrate B and sealing the periphery of the laminate in a conventional manner. The periphery may be sealed by a method wherein after the ion conductive film is placed on either of the substrates, a sealant is applied to the outside of the film and then the other substrate is laminated thereon or a method wherein a sealant and the ion conductive film are applied to the same substrate.

### [Best Mode of Carrying out the Invention]

The present invention will be described in more detail with reference to the following examples but are not limited thereto.

### (Example 1) (not according to the invention)

### (a) Preparation of an Ion Conductive Film

1 g of polyvinylidene fluoride was added to 4 g of a propylene carbonate solution containing 0.6 mol/L of lithium iodine and 0.1 mol/L of iodine and diluted with acetone. The mixture was heated thereby obtaining a uniform solution. The solution was coated on a polytetrafluoroethylene substrate by a doctor blade method and then dried by heating thereby obtaining a uniform ion conductive film with a thickness of 100 µ m.

The film was placed between two NESA glasses (electrodes) sputtered with Pt, and a voltage of 1 V was applied to the electrodes. From the current value which was constant at 3.5 mA, it was confirmed that the film exhibited reversible electrochemical oxidation-reduction characteristics. Furthermore, the film had a diffusion coefficient of 1.1 x 10⁻⁶ cm²/s and thus exhibited a sufficient ion conductivity.

### (b) Preparation of a Photoelectric Converting Device

Ti-Nanoxide T manufactured by SOLARONIX Co., Ltd. was bar-coated on an SnO₂:F glass (transparent electrically conductive glass obtained by forming an SnO₂:F film on a glass substrate) with a film resistivity of 10 Ω/sq and dried. When bar-coated, some pieces of Scotch-tape were attached to the sides of the transparent electrically conductive glass such that the thickness of the Ti-Nanoxide T was made uniform. The coated substrate was calcined at a temperature of 500 °C for 30 minutes thereby forming a semiconductor layer. The substrate was dipped into a ruthenium dye represented by the formula below /ethanol solution (3.0 x 10⁻⁴ mol/L) for 15 hours thereby making the dye absorbed.

Next, the ion conductive film obtained above was placed on the upper side of the semiconductor layer absorbing the dye, and the periphery was surrounded with an EVA film. Lastly, a Pt-coated glass was placed on the ion conductive film such that the Pt surface faced thereto thereby obtaining a photoelectric converting device.

A simulated sunlight was irradiated to the resulting cell so as to measure the current voltage characteristics. The photoelectric conversion efficiency of the cell was 3.8 percent and thus it was confirmed that the cell exhibited excellent photoelectric conversion characteristics.

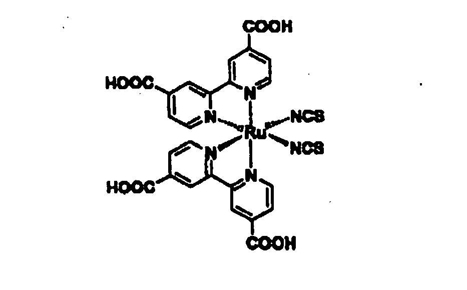

### (Example 2) (not according to the invention)

### (a) Preparation of an Ion Conductive Film

After 1 g of polyvinylidene fluoride was added to 4 g of a γ -butyrolactone solution containing 0.6 mol/L of lithium iodine, 0.5 mol/L of lithium perchloride, and 0.1 mmol/L of iodine thereby obtaining a solution, a uniform ion conductive film with a thickness of 100 µm was obtained with the same procedures of Example 1.

The film was placed between two NESA glasses (electrodes) sputtered with PT, and a voltage of 1 V was applied to the electrodes. From the current value which was constant at 2.6 mA, it was confirmed that the film exhibited reversible electrochemical oxidation-reduction characteristics. Furthermore, the film had a diffusion coefficient of 8 x 10⁻⁷ cm²/s and thus exhibited a sufficient ion conductivity.

### (b) Preparation of a Photoelectric Converting Device

A photoelectric converting device was prepared by the same method of Example 1 to measure the current voltage characteristics. The device had a photoelectric conversion efficiency of 3.3 percent and thus exhibited excellent photoelectric converting characteristics.

### (Example 3) (not according to the invention)

### (a) Preparation of an Ion Conductive Film

The same solution as obtained in Example 1 was coated on a polytetrafluoroethylene substrate by a doctor blade method and dried by heating thereby obtaining a uniform ion conductive film with a thickness of 100 µm.

A voltage was applied to the film in the same manner as Example 1 so as to measure the current characteristics thereby confirming that the film exhibited reversible electrochemical oxidation-reduction characteristics. The film had a diffusion coefficient of 1 x 10⁻⁶ cm²/s and thus exhibited a sufficient ion conductivity.

### (b) Preparation of a Photoelectric Converting Device

A solution obtained by dispersing 1 g of P-25 manufactured by Nippon Aero Gel Co., Ltd. in 4 mL of water was coated on a polyethylene terephthalate (PET) film having on its surface an ITO film masked on its periphery with some pieces of Scotch tape and having a film resistivity of 10 Ω /sq and air-dried. The PET film was heated at a temperature of 120 °C for 3 hours thereby obtaining a semiconductor layer. The PET film was dipped into the same ruthenium dye/ethanol solution (3.0 x 10⁻⁴ mol/L) as Example 1 for 15 hours thereby making the dye absorbed. The ion conductive film obtained above was placed on the upper side of the semiconductor layer absorbing the dye, whose periphery was surrounded with an EVA film. A Pt-coated PET film with ITO was placed on the ion conductive film such that the Pt surface faced thereto thereby obtaining a photoelectric converting device.

A simulated sunlight was irradiated to the resulting cell so as to measure the current voltage characteristics. The photoelectric conversion efficiency of the cell was 2.2 percent and thus it was confirmed that the cell exhibited excellent photoelectric conversion characteristics.

### (Example 4)

### (a) Preparation of an Ion Conductive Film

0.8 g of a vinylidene fluoride-hexafluoropropylene-acrylic acid copolymer (KF-9300 manufactured by Kureha Chemical Industry Co., Ltd.) was added to 4 g of a 3-methoxyacetonitrile solution containing 0.5 mol/L of 1-propyl-2,3dimethylimidazolium iodine, 0,1 mol/L of LiI, 0.05 mol/L of iodine, and 0.5 mol/L of 4-t-butylpyridine. The mixture was diluted with acetone and heated thereby obtaining a uniform solution. The solution was coated on an embossed (PET) film by a doctor blade method and dried at room temperature thereby obtaining a uniform ion conductive film with a thickness of 100 µm.

The film was placed between two NESA glasses (electrodes) sputtered with PT, and a voltage of 1 V was applied to the electrodes. From the current value which was constant at 4 mA, it was confirmed that the film exhibited reversible electrochemical oxidation-reduction characteristics. Furthermore, the film had a diffusion coefficient of 5.3 x 10⁻⁶ cm²/s and thus exhibited a sufficient ion conductivity.

### (b) Preparation of a Photoelectric Converting Device

Ti-Nanoxide T manufactured by SOLARONIX Co., Ltd. was bar-coated on an SnO₂:F glass (transparent electrically conductive glass obtained by forming an SnO₂:F film on a glass substrate) with a film resistivity of 10 Ω/sq and dried. When bar-coated, some pieces of Scotch-tape were attached to the sides of the transparent electrically conductive substrate such that the thickness of the Ti-Nanoxide T was made uniform. The coated substrate was calcined at a temperature of 500 °C for 30 minutes thereby forming a semiconductor layer. The thickness of the semiconductor layer was 12 µm. The substrate was dipped into a ruthenium dye (Rutenium 535-bis TBA manufactured by SOLARONIX Co., Ltd.)/ethanol solution (5.0 x 10⁻⁴ mol/L) for 30 hours thereby making the dye absorbed.

Next, the ion conductive film obtained above was placed on the upper side of the semiconductor layer, and the periphery was surrounded with an EVA film. Lastly, a Pt-coated glass was placed on the ion conductive film such that the Pt surface faced thereto thereby obtaining a photoelectric converting device.

A simulated sunlight was irradiated to the resulting cell so as to measure the current voltage characteristics. The photoelectric conversion efficiency of the cell was 6.0 percent and thus it was confirmed that the cell exhibited excellent photoelectric conversion characteristics.

### (Example 5)

### (a) Preparation of an Ion Conductive Film

0.8 g of a vinylidene fluoride-hexafluoropropylene-acrylic acid copolymer (KF-9300 manufactured by Kureha Chemical Industry Co., Ltd.) was added to 4 g of a 1-ethyl-3-methylimidazolium iodine solution containing 5 mass percent of water, 0.5 mol/L of LiI, 0.3 mol/L of iodine, and 0.5 mol/L of 4-t-butylpyridine. The mixture was diluted with acetone and heated thereby obtaining a uniform solution. The solution was coated on an embossed PET film by a doctor blade method and dried at room temperature thereby obtaining a uniform ion conductive film with a thickness of 100 µm.

The film was placed between two NESA glasses (electrodes) sputtered with PT, and a voltage of 1 V was applied to the electrodes. From the current value which was constant at 3.5 mA, it was confirmed that the film exhibited reversible electrochemical oxidation-reduction characteristics. Furthermore, the film had a diffusion coefficient of 1 x 10⁻⁶ cm²/s and thus exhibited a sufficient ion conductivity.

### (b) Preparation of a Photoelectric Converting Device

Ti-Nanoxide T manufactured by SOLARONIX Co., Ltd. was bar-coated on an SnO₂:F glass (transparent electrically conductive glass obtained by forming an SnO₂:F film on a glass substrate) with a film resistivity of 10 Ω/sq and dried. When bar-coated, some pieces of Scotch-tape were attached to the sides of the transparent electrically conductive substrate such that the thickness of the Ti-Nanoxide T was made uniform. The coated substrate was calcined at a temperature of 500 °C for 30 minutes thereby forming a semiconductor layer. The thickness of the semiconductor layer was 12 µm. The substrate was dipped into a ruthenium dye (Rutenium 535-bis TBA manufactured by SOLARONIX Co., Ltd.)/ethanol solution (5.0 x 10⁻⁴ mol/L) for 30 hours thereby making the dye absorbed.

Next, the ion conductive film obtained above was placed on the upper side of the semiconductor layer, and the periphery was surrounded with an EVA film. Lastly, a Pt-coated glass was placed on the ion conductive film such that the Pt surface faced thereto thereby obtaining a photoelectric converting device.

A simulated sunlight was irradiated to the resulting cell so as to measure the current voltage characteristics. The photoelectric conversion efficiency of the cell was 4.5 percent and thus it was confirmed that the cell exhibited excellent photoelectric conversion characteristics.

### (Example 6)

Titanium oxide electrodes with a regulated structure as shown in Fig. 2 (the numerals in Fig. 2 are the same as those in Fig. 1) were prepared on an SnO₂:F glass (transparent electrically conductive glass obtained by forming an SnO₂:F film on a glass substrate) with a film resistivity of 10 Ω/sq in accordance with a literature "Chem. Mater. 14, 266 (2002)" by S.-Z. Chu, K. Wada, S. Inoue and S. Todoroki. The glass was dipped into a ruthenium dye (Rutenium 535-bis TBA manufactured by SOLARONIX Co., Ltd.)/ethanol solution (5.0 x 10⁻⁴ mol/L) for 30 hours thereby making the dye absorbed.

Next, the ion conductive film obtained in Example 5 was on the upper side of the semiconductor layer, and the periphery was surrounded with an EVA film. Lastly, a Pt-coated glass was placed on the ion conductive film such that the Pt surface faced thereto thereby obtaining a photoelectric converting device.

A simulated sunlight was irradiated to the resulting cell so as to measure the current voltage characteristics. The photoelectric conversion efficiency of the cell was 6 percent and thus it was confirmed that the cell exhibited excellent photoelectric conversion characteristics.

### [Applicability in the Industry]

The photoelectric converting device of the present invention has a solid electrolyte and thus exhibits excellent characteristics such as high ion conductivity, mechanical strength, and long term stability. Furthermore, the photoelectric converting device can be easily produced because the electrolyte layer is in the form of a film.

### [Brief Description of the Drawings]

Fig. 1 is a cross-section of a photoelectric converting device.
Fig. 2 shows a regulated structure of the titanium oxide electrodes used in Example 6.

## Claims

1. A photoelectric converting device having a semiconductor layer with a metal complex or an organic dye absorbing thereto and an electrolyte layer as a charge transport layer wherein said electrolyte layer is an ion conductive film exhibiting reversible electrochemical oxidation-reduction characteristics, said ion conductive film comprises a polymer matrix and said polymer matrix is a copolymer of at least vinylidene fluoride and hexafluoropropylene.

2. The photoelectric converting device according to claim 1 wherein said ion conductive film comprises a polymeric matrix containing therein at least a substance exhibiting reversible electrochemical oxidation-reduction characteristics.

3. The photoelectric converting device according to claim 1 wherein the ion conductive film contains at least (b) a plasticizer and (c) a substance exhibiting reversible electrochemical oxidation-reduction characteristics in (a) a polymeric matrix.

4. The photoelectric converting device according to claim 1 wherein said copolymer is a copolymer of vinylidene fluoride, hexafluoropropylene, and acrylic acid.

## Patentansprüche

1. Photoelektrische Umwandlungsvorrichtung mit einer Halbleiterschicht mit einem Metallkomplex oder einem organischen Farbstoff, die daran absorbieren, und einer Elektrolytschicht als Ladungstransportschicht, wobei die Elektrolytschicht ein ionenleitender Film ist, der reversible elektrochemische Oxidations-Reduktions-Eigenschaften aufweist, wobei der ionenleitende Film eine Polymermatrix umfasst und die Polymermatrix ein Copolymer aus wenigstens Vinylidenfluorid und Hexafluorpropylen ist.

2. Photoelektrische Umwandlungsvorrichtung nach Anspruch 1, wobei der ionenleitende Film eine polymere Matrix umfasst, die darin wenigstens eine Substanz enthält, die reversible elektrochemische Oxidations-Reduktions-Eigenschaften aufweist.

3. Photoelektrische Umwandlungsvorrichtung nach Anspruch 1, wobei der ionenleitende Film wenigstens (b) einen Weichmacher und (c) eine Substanz, die reversible elektrochemische Oxidations-Reduktions-Eigenschaften aufweist, in (a) einer polymeren Matrix enthält.

4. Photoelektrische Umwandlungsvorrichtung nach Anspruch 1, wobei das Copolymer ein Copolymer aus Vinylidenfluorid, Hexafluorpropylen und Acrylsäure ist.

## Revendications

1. Dispositif de conversion photoélectrique ayant une couche de semi-conducteur avec un colorant organique ou à complexe métallique s'y absorbant, et une couche d'électrolyte servant de couche de transport de charge, dans lequel ladite couche d'électrolyte est un film conducteur d'ions présentant des caractéristiques d'oxydoréduction électrochimique réversible, ledit film conducteur d'ions comprenant une matrice polymère, et ladite matrice polymère étant un copolymère au moins de fluorure de vinylidène et d'hexafluoropropylène.

2. Dispositif de conversion photoélectrique selon la revendication 1, dans lequel ledit film conducteur d'ions comprend une matrice polymère contenant dans celle-ci au moins une substance présentant des caractéristiques d'oxydoréduction électrochimique réversible.

3. Dispositif de conversion photoélectrique selon la revendication 1, dans lequel le film conducteur d'ions contient au moins (b) un plastifiant et (c) une substance présentant des caractéristiques d'oxydo-réduction électrochimique réversible dans (a) une matrice polymère.

4. Dispositif de conversion photoélectrique selon la revendication 1, dans lequel ledit copolymère est un copolymère de fluorure de vinylidène, d'hexafluoropropylène et d'acide acrylique.
